# EUROPEAN PATENT APPLICATION

(11) **EP 4 556 869 A1**
(43) Date of publication of application: **21.05.2025**
(21) Application number: 23210087.5
(22) Date of filing: 15.11.2023
(51) Int. Cl.: G01J 3/28

(54) **METHODS AND ASSEMBLIES FOR WAVELENGTH CALIBRATION**

(71) Applicant: ASML Netherlands B.V., 5500 AH Veldhoven (NL)
(72) Inventor: VAN DER POST, Sietse Thijmen, 5500 AH Veldhoven (NL); SMORENBURG, Petrus Wilhelmus, 5500 AH Veldhoven (NL); ROSCAM ABBING, Sylvianne Dorothea Christina, 5500 AH Veldhoven (NL); JANSEN, Elmer Wolter, 5500 AH Veldhoven (NL); BALMES, Olivier, 5500 AH Veldhoven (NL)
(74) Representative: ASML Netherlands B.V.

(57) **Abstract**

Assemblies and methods for wavelength calibration of radiation. The assembly comprises one or more spectrometers configured to measure a first radiation spectrum of the radiation. The assembly then measures a second radiation spectrum while a gas is present in a propagation path of the radiation. The gas has an absorption line that overlaps with at least one wavelength of the radiation. The assembly optionally further comprises a processor configured to determine a wavelength calibration of the one or more spectrometers based on a difference between the second radiation spectrum and the first radiation spectrum.

## Description

### FIELD

The present invention relates to methods and assemblies for wavelength calibration of one or more spectrometers in a metrology apparatus. Specifically, it relates to using an absorption line of a gas for absolute wavelength calibration for short wavelength applications.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-kₗ lithography may be used to process features with dimensions smaller than the classical resolution limit of a lithographic apparatus. In such process, the resolution formula may be expressed as CD = kₗ×λ/NA, where λ is the wavelength of radiation employed, NA is the numerical aperture of the projection optics in the lithographic apparatus, CD is the "critical dimension" (generally the smallest feature size printed, but in this case half-pitch) and kₗ is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low kₗ.

In lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

The manufacturing processes may be for example lithography, etching, deposition, chemical mechanical planarization, oxidation, ion implantation, diffusion or a combination of two or more of them.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

In short wavelength metrology, a target may be illuminated by broadband radiation, and scattered radiation (e.g. from diffraction orders) may be detected by one or more detectors. The detected radiation may be analyzed for example to reconstruct relevant parameters of the target. In certain metrology applications, a plurality of parameters may be reconstructed at once, based on the same detected scattered radiation. This may be referred to as profilometry. In such applications, accurate calibration of the detectors capturing the scattered radiation is important to obtain accurate profilometry results.

### SUMMARY

According to an aspect of the current disclosure there is provided an assembly for wavelength calibration of radiation. The assembly comprises one or more spectrometers configured to measure a first radiation spectrum of the radiation. The one or more spectrometers are further configured to measure a second radiation spectrum while krypton gas is present in a propagation path of the radiation. The krypton gas has an absorption line that overlaps with at least one wavelength of the radiation. The assembly further comprises a processor configured to determine a wavelength calibration of the one or more spectrometers based on a difference between the second radiation spectrum and the first radiation spectrum.

Optionally, the difference may be a ratio of the second radiation spectrum to the first radiation spectrum. Optionally, the difference may be a subtraction of the second radiation spectrum from the first radiation spectrum.

Optionally, the radiation may comprise one or more wavelengths in a range of 1 nm to 100 nm, or 1 nm to 10 nm, or 10 nm to 20 nm, or 0.1 nm to 10 nm.

Optionally, the assembly may comprise a plurality of spectrometers. The assembly may be configured to determine a wavelength calibration of each of the plurality of spectrometers.

Optionally, the processor may be configured to, to determine the wavelength calibration, for each of the one or more spectrometers identify a position on the spectrometer where the absorption line of the krypton gas is located based on the difference of the second radiation spectrum and the first radiation spectrum. The processor may further be configured to calibrate the wavelength corresponding to the absorption line of krypton to the position of the absorption line.

Optionally, the absorption line of krypton may be associated with a photon energy in a range of 90 eV to 95 eV, such as with a wavelength of 13.5 nm.

Optionally, the one or more spectrometers may be configured to be provided inside a metrology or inspection vessel. The radiation may be configured to propagate inside the metrology or inspection vessel. The krypton gas may be configured to be added to the metrology or inspection vessel.

Optionally, the assembly may further comprise a gas module configured to add krypton gas inside the metrology or inspection vessel at a pressure in a range of 0.0001 mbar to 1 mbar, such as a pressure of 0.01 mbar.

Optionally, the propagation length of the radiation inside the metrology or inspection apparatus may be in a range of 10 cm to 5 m, such as in a range from 50 cm - 70 cm.

Optionally, the assembly may further comprise a gas cell. The krypton gas may be configured to be added to the gas cell.

Optionally, the gas cell may comprise an inlet tube and two outlet tubes for the krypton gas in and out, respectively. The outlet tubes may be configured to function as an input end of the gas cell and an output end of the gas cell for the radiation.

Optionally, the propagation length of the radiation in the gas cell may be in a range of 5 mm and 20 cm, such as 10 cm.

Optionally, measuring a first radiation spectrum and a second radiation spectrum may comprise performing lock-in detection.

Optionally, the one or more spectrometers may comprise a spectrometer in a reference arm of a metrology or inspection apparatus.

Optionally, the one or more spectrometers may comprise a spectrometer in a measurement arm of the metrology or inspection apparatus.

According to another aspect of the current disclosure there is provided an assembly. The assembly comprises a radiation input configured to receive an emitted radiation, and an illumination system arranged to irradiate at least part of the emitted radiation on the structure to generate one or more scattered radiations. The assembly further comprises multiple detectors. At least part of the multiple detectors are arranged to detect at least part of the one or more scattered radiations or at least part of the emitted radiation. The assembly further comprises a gas supply system configured to provide a gas to absorb part of the emitted radiation to create an absorption line on spectrums of the one or more scattered radiations and the at least part of the emitted radiation. Optionally the multiple detectors are configured to measure the absorption line simultaneously.

According to another aspect of the current disclosure there is provided a method for wavelength calibration of radiation. The method comprises measuring, by one or more spectrometers, a first radiation spectrum of the radiation. The method comprises measuring, by the one or more spectrometers, a second radiation spectrum while krypton gas is present in the propagation path of the radiation. The krypton gas has an absorption line that overlaps with at least one wavelength of the radiation. The method further comprises determining, by a processor, a wavelength calibration of the one or more spectrometers based on a difference between the second radiation spectrum and the first radiation spectrum.

According to another aspect of the current disclosure there is provided an assembly for wavelength calibration of radiation. The assembly comprises one or more spectrometers, configured to measure a first radiation spectrum of the radiation, and to measure a second radiation spectrum while helium gas is present in a propagation path of the radiation. The helium gas has an absorption line that overlaps with at least one wavelength of the radiation. The assembly further comprises a processor configured to determine a wavelength calibration of the one or more spectrometers based on a difference between the second radiation spectrum and the first radiation spectrum.

According to another aspect of the current disclosure there is provided an assembly for wavelength calibration of radiation. The assembly comprises one or more spectrometers configured to measure a first radiation spectrum of the radiation, and measure a second radiation spectrum while a wavelength-selective filter is present in a propagation path of the radiation. The wavelength-selective filter has an absorption line that overlaps with at least one wavelength of the radiation. The assembly further comprises a processor configured to determine a wavelength calibration of the one or more spectrometers based on a difference between the second radiation spectrum and the first radiation spectrum.

Optionally, the wavelength-selective filter may be a solid thin film filter.

Optionally, the wavelength-selective filter may be a transmissive filter.

Optionally, the wavelength-selective filter may be a multi-cavity filter.

Optionally, the wavelength-selective filter may be a reflective filter.

Optionally, the wavelength-selective filter may be a multilayer mirror.

Optionally, the angle of incidence of the radiation onto the reflective filter may be selected to tune the reflected wavelengths.

According to another aspect of the current disclosure there is provided an assembly for wavelength calibration of radiation. The assembly comprises one or more spectrometers configured to measure a first radiation spectrum of the radiation, and to measure a second radiation spectrum while a first wavelength-selecting element and a second wavelength-selecting element are present in a propagation path of the radiation. The first wavelength-selecting element has a first absorption line that overlaps with at least a first wavelength of the radiation. The second wavelength-selecting element has a second absorption line that overlaps with at least a second wavelength of the radiation. The first wavelength and the second wavelength are different. The assembly further comprises a processor configured to determine a wavelength calibration of the one or more spectrometers based on a difference between the second radiation spectrum and the first radiation spectrum.

Optionally, the first wavelength-selecting element may be one of a solid thin film, Krypton gas, Helium gas, a transmissive filter, or a reflective filter.

Optionally, the second wavelength-selecting element may be not identical to the first wavelength-selecting element. The second wavelength-selective element may be one of a solid thin film, Krypton gas, Helium gas, a transmissive filter, or a reflective filter.

According to another aspect of the current disclosure there is provided a metrology apparatus comprising an assembly as described above.

According to another aspect of the current disclosure there is provided an inspection apparatus comprising an assembly as described above.

According to another aspect of the current disclosure there is provided a lithography apparatus comprising an assembly as described above.

According to another aspect of the current disclosure there is provided a litho cell comprising an apparatus as described above.

### BRIEF DESCRIPTION OF THE DRAWINGS

Embodiments will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 schematically illustrates a transmissive scatterometry apparatus;
- Figure 6 depicts a schematic representation of a metrology apparatus in which EUV and/or SXR radiation is used;
- Figure 7 depicts a simplified schematic drawing of an illumination source;
- Figure 8 depicts a schematic representation of an assembly for wavelength calibration;
- Figure 9 depicts a schematic representation of a gas cell to be included in an assembly for wavelength calibration;
- Figure 10 depicts a flow diagram of steps in a method for wavelength calibration;
- Figure 11 depicts a schematic representation of an assembly for wavelength calibration;
- Figure 12 depicts a schematic graph of transmission by a transmissive filter as a function of wavelength; and
- Figure 13 depicts a model graph of reflectivity for a multilayer mirror for different angles of incidence.

### DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-100 nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

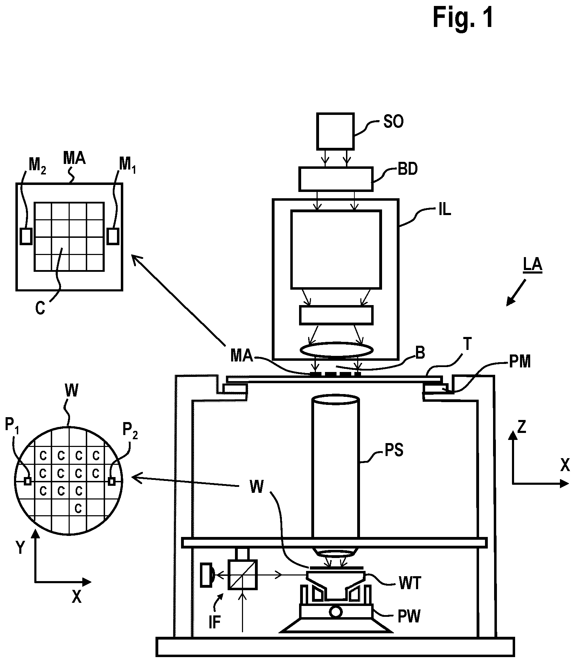

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

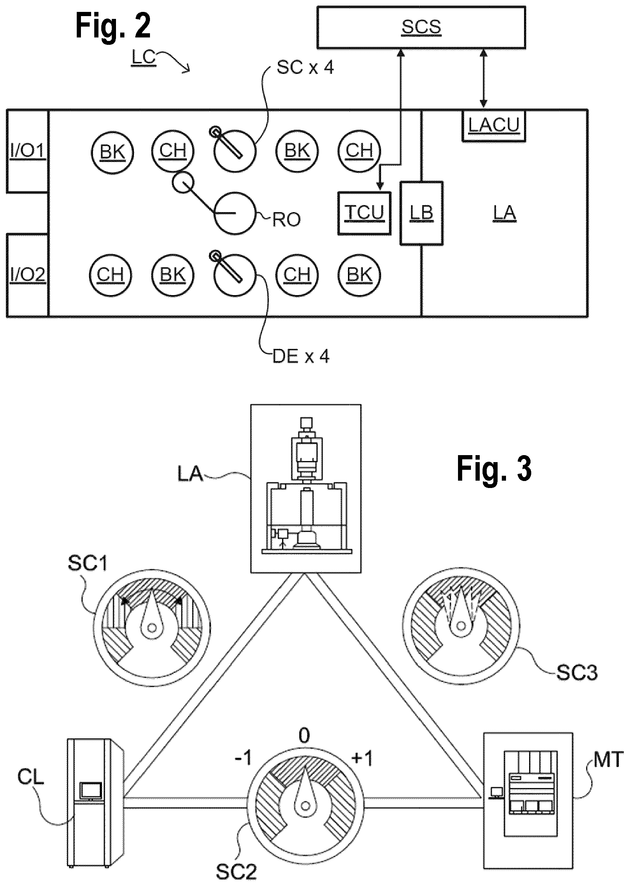

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1incorporated herein by reference in its entirety.

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

Many different forms of metrology tools MT for measuring structures created using lithographic pattering apparatus can be provided. Metrology tools MT may use electromagnetic radiation to interrogate a structure. Properties of the radiation (e.g. wavelength, bandwidth, power) can affect different measurement characteristics of the tool, with shorter wavelengths generally allowing for increased resolution. Radiation wavelength has an effect on the resolution the metrology tool can achieve. Therefore, in order to be able to measure structures with features having small dimensions, metrology tools MT with short wavelength radiation sources are preferred.

Another way in which radiation wavelength can affect measurement characteristics is penetration depth, and the transparency/opacity of materials to be inspected at the radiation wavelength. Depending on the opacity and/or penetration depth, radiation can be used for measurements in transmission or reflection. The type of measurement can affect whether information is obtained about the surface and/or the bulk interior of a structure/substrate. Therefore, penetration depth and opacity are another element to be taken into account when selecting radiation wavelength for a metrology tool.

In order to achieve higher resolution for measurement of lithographically patterned structures, metrology tools MT with short wavelengths are preferred. This may include wavelengths shorter than visible wavelengths, for example in the UV, EUV, and X-ray portions of the electromagnetic spectrum. Hard X-ray methods such as Transmitted Small Angle X-ray Scattering (TSAXS) make use of the high resolution and high penetration depth of hard X-rays and may therefore operate in transmission. Soft X-rays and EUV, on the other hand, do not penetrate the target as far but may induce a rich optical response in the material to be probed. This may be due the optical properties of many semiconductor materials, and due to the structures being comparable in size to the probing wavelength. As a result, EUV and/or soft X-ray metrology tools MT may operate in reflection, for example by imaging, or by analyzing diffraction patterns from, a lithographically patterned structure.

For hard X-ray, soft X-ray and EUV radiations, applications in high volume manufacturing (HVM) applications may be limited due to a lack of available high-brilliance radiation sources at the required wavelengths. In the case of hard X-rays, commonly used sources in industrial applications include X-ray tubes. X-ray tubes, including advanced X-ray tubes for example based on liquid metal anodes or rotating anodes, may be relatively affordable and compact, but may lack brilliance required for HVM applications. High brilliance X-ray sources such as Synchrotron Light Sources (SLSs) and X-ray Free Electron Lasers (XFELs) currently exist, but their size (>100m) and high cost (multi-100-million euro), makes them prohibitively large and expensive for metrology applications. Similarly, there is a lack of availability of sufficiently bright EUV and soft X-ray radiation sources.

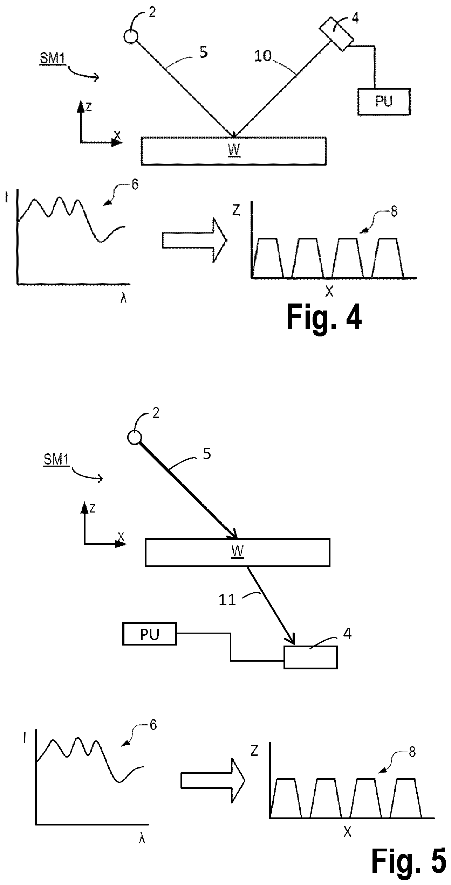

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A transmissive version of the example of a metrology apparatus, such as a scatterometer shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer. Optionally, the transmissive version using hard X-ray radiation with wavelength < 1nm, optionally <0.1nm, optionally <0.01nm.

As an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

It is possible that the range of application makes the use of wavelengths in e.g. the hard-X-rays, soft X-rays or EUV domain not sufficient. Published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling an x-ray mathematical model and an optical mathematical model through one or more common. The contents of the cited US patent applications are incorporated herein by reference in their entirety.

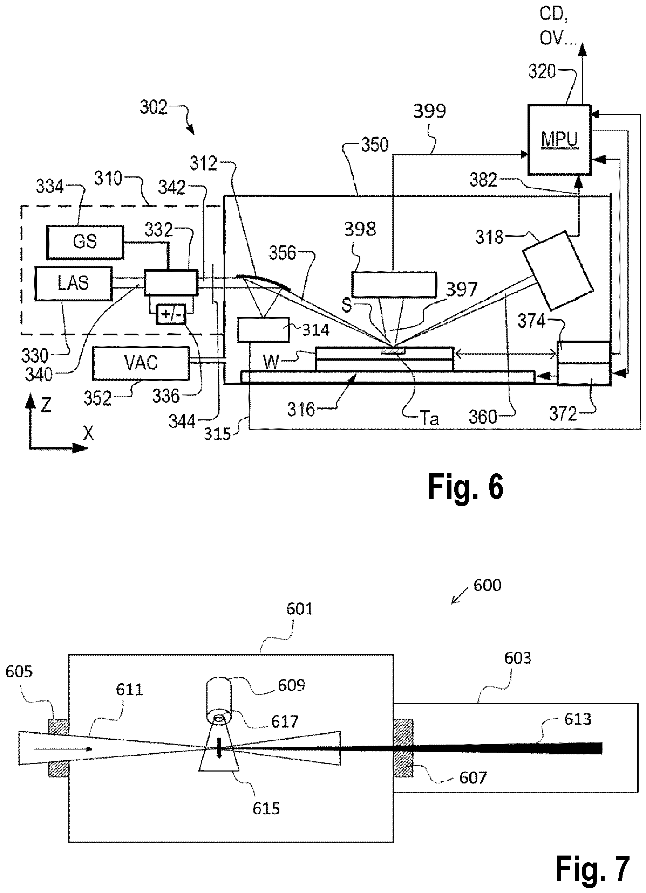

Figure 6 depicts a schematic representation of a metrology apparatus 302 in which the aforementioned radiation may be used to measure parameters of structures on a substrate. The metrology apparatus 302 presented in Figure 6 may be suitable for the hard X-ray, soft X-rays and/or EUV domain.

Figure 6 illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer, to which the configuration in Figure 5 applies.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 6, and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 6, main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10µm, for example in the region of 1 µm (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N₂), Oxygen (O₂), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 µm in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397. Both the reflected radiation and the diffracted radiation may be referred as scattered radiation.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV, hard X-ray (HXR) and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) or any other types of sources mentioned above to obtain radiation at the desired wavelength(s).

Figure 7 shows a simplified schematic drawing of an embodiment 600 of an illumination source 310, which may be the illumination source for high harmonic generation (HHG). One or more of the features of the illumination source in the metrology tool described with respect to Figures 6 may also be present in the illumination source 600 as appropriate. The illumination source 600 comprises a chamber 601 and is configured to receive a pump radiation 611 with a propagation direction which is indicated by an arrow. The pump radiation 611 shown here is an example of the pump radiation 340 from the pump radiation source 330, as shown in Figure 6. The pump radiation 611 may be directed into the chamber 601 through the radiation input 605, which maybe a viewport, optionally made of fused silica or a comparable material. The pump radiation 611 may have a Gaussian or hollow, for example annular, transversal cross-sectional profile and may be incident, optionally focused, on a gas flow 615, which has a flow direction indicated by a second arrow, within the chamber 601. The gas flow 615 comprises a small volume called gas volume or gas target (for example several cubic mm) of a particular gas (for example, air, Neon (Ne), Helium (He), Nitrogen (N₂), Oxygen (O₂), Argon (Ar), Krypton (Kr), Xenon (Xe), Carbon dioxide and the combination of them.) in which the gas pressure is above a certain value. The gas flow 615 may be a steady flow. Other media, such as metallic plasmas (e.g. aluminium plasma) may also be used.

The gas delivery system of the illumination source 600 is configured to provide the gas flow 615. The illumination source 600 is configured to provide the pump radiation 611 in the gas flow 615 to drive the generation of emitted radiation 613. The region where at least a majority of the emitted radiation 613 is generated is called an interaction region. The interaction region may vary from several tens of micrometers (for tightly focused pump radiation) to several mm or cm (for moderately focused pump radiation) or even up to a few meters (for extremely loosely focused pump radiation). The gas delivery system is configured to provide the gas target for generating the emitted radiation at the interaction region of the gas target, and optionally the illumination source is configured to receive the pump radiation and to provide the pump radiation at the interactive region. Optionally, the gas flow 615 is provided by the gas delivery system into an evacuated or nearly evacuated space. The gas delivery system may comprise a gas nozzle 609, as shown in Figure 6, which comprises an opening 617 in an exit plane of the gas nozzle 609. The gas flow 615 is provided from the opening 617. The gas catcher is for confining the gas flow 615 in a certain volume by extracting residual gas flow and maintaining a vacuum or near vacuum atmosphere inside the chamber 601. Optionally the gas nozzle 609 may be made of thick-walled tube and/or high thermo-conductivity materials to avoid thermo deformation due to the high-power pump radiation 611.

The dimensions of the gas nozzle 609 may conceivably also be used in scaled-up or scaled-down versions ranging from micrometer-sized nozzles to meter-sized nozzles. This wide range of dimensioning comes from the fact that the setup may be scaled such that the intensity of the pump radiation at the gas flow ends up in the particular range which may be beneficial for the emitted radiation, which requires different dimensioning for different pump radiation energies, which may be a pulse laser and pulse energies can vary from tens of microjoules to joules. Optionally, the gas nozzle 609 has a thicker wall to reduce nozzle deformation caused by the thermal expansion effect, which may be detected by e.g. a camera. The gas nozzle with thicker wall may produce a stable gas volume with reduced variation. Optionally, the illumination source comprises a gas catcher which is close to the gas nozzle to maintain the pressure of the chamber 601.

Due to interaction of the pump radiation 611 with the gas atoms of the gas flow 615, the gas flow 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm.

In operation the emitted radiation 613 beam may pass through a radiation output 607 and may be subsequently manipulated and directed by an illumination system 603, which may be an example of the illumination system 312 in Figure 6, to a substrate to be inspected for metrology measurements. The emitted radiation 613 may be guided, optionally focused, to a structure on the substrate.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the pump radiation (e.g. opaque or nearly opaque to infrared or visible light) but at least partially transparent to the emitted radiation beam. The filter may be manufactured using zirconium or multiple materials combined in multiple layers. The filter may be a hollow, optionally an annular, block when the pump radiation 611 has a hollow, optionally an annular, transversal cross-sectional profile. Optionally, the filter is non-perpendicular and non-parallel to propagation direction of the emitted radiation beam to have efficient pump radiation filtering. Optionally, the filtering device 344 comprise a hollow block and a thin membrane filter such as an Aluminum (Al) or Zirconium (Zr) membrane filter. Optionally, the filtering device 344 may also comprise mirrors that efficiently reflect the emitted radiation but poorly reflect the pump radiation, or comprise a wire mesh that efficiently transmits the emitted radiation but poorly transmits the pump radiation.

Described herein are methods, apparatuses, and assemblies to obtain emitted radiation optionally at a high harmonic frequency of pump radiation. The radiation generated through the process, optionally the HHG which uses non-linear effects to generate radiation optionally at a harmonic frequency of provided pump radiation, may be provided as radiation in metrology tools MT for inspection and/or measurement of substrates. If the pump radiation comprises short pulses (i.e. few-cycle) then the generated radiation is not necessarily exactly at harmonics of the pump radiation frequency. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 500 nm to 1500 nm. The pump radiation may comprise radiation with wavelength(s) in the range of 800 nm to 1300 nm. The pump radiation may comprise radiation with wavelength(s) in the range of 900 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet, soft X-Ray, and/or hard X-Ray part of the electromagnetic spectrum. The emitted radiation 613 may comprise wavelengths in one or more of the ranges of less than 1nm, less than 0.1nm, less than 0.01nm, 0.01 nm to 100 nm, 0.1 nm to 100 nm, 0.1 nm to 50 nm, 1 nm to 50 nm and 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV, SXR and/or HXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUVSXR and/or HXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUVSXR and/or HXR radiation. The target structure may reflect, transmit and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected or transmitted radiation (0th order diffracted radiation). Further sensors for metrology may be present in the metrology tool MT, for example to measure further diffraction orders (e.g. higher diffraction orders).

In an example lithographic metrology application, the HHG generated radiation may be focused onto a target on the substrate using an optical column, which may be referred to as an illuminator, which transfers the radiation from the HHG source to the target. The HHG radiation may then be reflected from the target, detected and processed, for example to measure and/or infer properties of the target.

Gas target HHG configurations may be broadly divided into three separate categories: gas jets, gas cell and gas capillaries. Figure 7 depicts an example gas jet configuration in which as gas volume is introduced into a drive radiation laser beam. In a gas jet configuration, interaction of the drive radiation with solid parts is kept to a minimum. The gas volume may for example comprise a gas stream perpendicular to the drive radiation beam, with the gas volume enclosed inside a gas cell. In a gas capillary setup, the dimensions of the capillary structure holding the gas are small in a lateral direction such that it significantly influences the propagation of the drive radiation laser beam. The capillary structure may for example be a hollow-core fibre, wherein the hollow core is configured to hold the gas.

A gas jet HHG configuration may offer a relative freedom to shape a spatial profile of the drive radiation beam in the far field, as it is not confined by the restrictions imposed by the gas capillary structure. Gas jet configurations may also have less stringent alignment tolerances. On the other hand, a gas capillary may provide an increased interaction zone of the drive radiation and the gaseous medium, which may optimise the HHG process.

In order to use the HHG radiation, for example in a metrology application, it is separated from the drive radiation downstream of the gas target. The separation of the HHG and drive radiation may be different for the gas jet and gas capillary configurations. In both cases, the drive radiation rejection scheme can comprise a metal transmissive filter for filtering out any remaining drive radiation from the short wavelength radiation. However, before such a filter can be used, the intensity of the drive radiation should be reduced significantly from its intensity at the gas target, in order to avoid damage to the filter. The methods that can be used for this intensity reduction differ for the gas jet and capillary configurations. For a gas jet HHG, due to the relative freedom of the shape and spatial profile (which may also be referred to as a spatial distribution, and/or spatial frequencies) of the drive radiation beam focussed onto the gas target, this can be engineered such that in the far field it has a low intensity along the directions where the short wavelength radiation propagates. This spatial separation in the far field means an aperture may be used to block the drive radiation and lower its intensity

In contrast, in a gas capillary structure, the spatial profile of the beam as it passes through the gaseous medium may be largely dictated by the capillary. The spatial profile of the drive radiation may be determined by the shape and material of the capillary structure. For example, in the case of a hollow-core fiber being used as a capillary structure, the shape and materials of the fiber structure determine which modes of drive radiation are supported for propagation through the fiber. For most standard fibres, the supported propagating modes lead to a spatial profile where the high intensity of the drive radiation overlaps with the high intensity of the HHG radiation. For example, the drive radiation intensity may be centred, in a Gaussian or close-to-Gaussian profile in the far field.

Although specific reference is made to HHG, it will be appreciated that the invention, where the context allows, may be practiced with all radiation sources. In one embodiment, the radiation source is a laser produced plasma (LPP) source as mentioned above, for hard X-ray, soft X-ray, EUV, DUV as well as visible illumination generation. In one embodiment, the radiation source is one of liquid metal jet source, inverse Compton scattering (ICS) source, plasma channel source, magnetic undulator source, free electron laser (FEL) source, compact storage ring source, electrical discharge produced plasma source, rotating anode source, solid anode source, particle accelerator source, and microfocus source.

The HHG radiation described herein may be used in an inspection and/or metrology apparatus. The inspection/metrology apparatus may be used for inspection/metrology of a lithographic substrate. The metrology may for example perform measurements to determine one or more parameters of a lithographically patterned structure on a substrate. In one embodiment, the substrate is a patterning device (e.g., a mask). In one embodiment, the substrate is a semiconductor wafer. As the dimensions of the structure may be small, the inspection/metrology apparatus may use short wavelength radiation. The inspection/metrology apparatus may include detection of short wavelength radiation scattered from a target structure. The scattered radiation may comprise diffracted radiation (zeroth and/or non-zeroth diffraction orders). The diffracted radiation may be measured by one or more detectors, such as a spectrometer. The detected wavelengths may for example be used for reconstruction of the target structure and/or measurement of a parameter of interest. In order to achieve accurate measurements, the detectors may be calibrated to measure the radiation. The calibration may be specific to the radiation and/or the inspection/metrology setup used in the specific inspection/metrology apparatus. Achieving accurate calibration in short wavelength setups may involve challenges.

A target structure may diffract different wavelengths to difference positions on a detector. As a result, the intensity of radiation detected in each position may inherit/represent properties of the incident diffracted wavelength. Wavelength information may therefore be used to deconvolve the target structure response from the radiation beam properties, and ultimately to for example reconstruct the target structure. A challenge in using this information may be that short wavelength radiation beam profiles can be sensitive to tiny aberrations present in the drive laser used to generate the HHG radiation.

Although the embodiments are applicable to both metrology apparatus and inspection apparatus, only metrology apparatus will be mentioned in the following embodiments as example.

In an example implementation, a calibration may be performed using a metrology device that is positioned outside of the radiation path during use of the metrology setup. A downside of using such a setup may be that it requires an adjustment of the metrology setup compared to when a measurement is taken. As a result, such a calibration may not be possible in real-time. A real-time calibration may be desirable, especially for HVM applications. One example implementation may be to perform a calibration of the radiation beam in a separate branch that is separate from a measurement branch of the radiation. This separate branch may be referred to as a reference branch.

In an example, wavelength calibration of a spectrometer may be done by reconstructing the geometry of the spectrometer, using measurement data of that spectrometer and approximate knowledge of the characteristics of the HHG radiation source providing the radiation. However, this in itself may be insufficient, as there may be too many unknowns/assumptions in the process. To further aid the calibration, additional measurements may be performed using absorption features of one or more materials. In order to work, the wavelengths at which absorption occurs should overlap with wavelengths of the radiation.

An aluminium filter may be used in the radiation beam (before it hits the spectrometer). Aluminium has a very pronounced drop in transmission towards wavelengths of around 17 nm. This transmission drop may be referred to as the aluminium edge. Using this drop in transmission around a known wavelength in the spectrum may help anchor the spectrum. The aluminium edge filter method may have disadvantages that lead it to not be accurate enough to obtain accurate calibration. The exact position of the aluminium edge (or any absorption edge in general) may change depending on the chemical environment. Processes such as oxidation or carbon growth on the aluminium filter may also change the position of the edge. Furthermore, the aluminium edge may have limited usefulness if it is located in a part of the spectrum of the radiation source where the intensity is low. For example, in sources that use zirconium filters (for rejection of infrared radiation) the wavelengths around 17 nm may be low due to zirconium already suppressing transmission around this wavelength. Any following transmission suppression around 17 nm by the aluminium filter may have limited/hard-to-detect effects. These disadvantages make use of an aluminium filter for absolute calibration difficult and more ambiguous. Provided herein are methods and assemblies for improved accuracy of wavelength calibration in metrology setups.

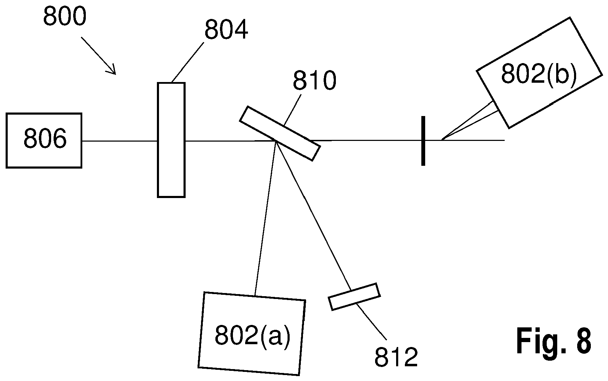

Figure 8 depicts an assembly 800 for wavelength calibration of radiation which may be used in a metrology or inspection apparatus. The assembly may be provided in (e.g. form part of) the metrology or inspection apparatus. Optionally the assembly for measuring a parameter of a structure (or target structure) on a substrate. Optionally the assembly is for inspecting defects on a substrate, optionally the substrate is a substrate exposed by a lithographic apparatus and optionally the substrate is a mask for exposing a pattern on to another substrate. The assembly comprises one or more spectrometers or detectors 802(a) - 802(b), wherein the radiation is to be calibrated in relation to the spectrometers 802(a) - 802(b) measuring the radiation wavelength(s). In one embodiment, the assembly comprises multiple spectrometers or detectors 802(a) - 802(b). The one or more spectrometers 802(a) - 802(b) may comprises one or more of the detectors (or detector systems) 314, 318 and 398 in Figure 6. The one or more spectrometers 802(a) - 802(b) are configured to measure a first radiation spectrum of the radiation. Once the first radiation spectrum has been measured, a gas, optionally a noble gas, optionally a krypton or helium gas, is added to a propagation path. A gas supply system, which may comprises a gas provision module 804, may be added to the assembly for controlling krypton gas provision. The gas supply system is configured to provide a gas to absorb part of a radiation, e.g. the emitted radiation, to create an absorption line on spectrums of the one or more scattered radiations and/or the at least part of the emitted radiation. The spectrums may be different on the multiple detectors. In one embodiment, the at least part of the multiple detectors are arranged to detect the at least part of the one or more scattered radiations to measure the parameter. Optionally the parameter is a profilometry parameter. Optionally the parameter is a overlay parameter. Optionally the parameter is a critical dimension (CD) parameter. The krypton gas has the absorption line that overlaps with at least one wavelength of the radiation. While the krypton gas is present in the propagation path of the radiation, the one or more spectrometers 802(a) - 802(b) measure a second radiation spectrum of the radiation. A wavelength calibration is determined for the one or more spectrometers based on a difference between the second radiation spectrum and the first radiation spectrum. In one embodiment, the absorption line is used for measuring the spectrums of the one or more scattered radiations and/or the at least part of the emitted radiation.

The radiation to be wavelength calibrated may comprise short wavelength radiation, such as (EUV) radiation (e.g. 1 nm to 100 nm), and/or soft X-ray (SXR) radiation (e.g. 0.1 nm to 10 nm). The radiation may for example comprise wavelengths in a range from 1 nm - 100 nm, in a range of 1 nm - 10 nm, in a range of 10 nm - 20 nm, in a range of 0.1 nm to 10 nm, or in a range of 1 nm - 7.5 nm.

An advantage of an assembly as described in relation to figure 8 above, is that it may enable an absolute calibration of the radiation. This may be because one of the absorption lines of krypton gas occurs at a photon energy around 92 eV (such as in a range of 90 eV to 95 eV), in which photon energy and wavelength have the following relation: E = h*c/λ (E = photon energy; h = Planck's constant; c = speed of light; λ = wavelength). The absorption peak of krypton gas may occur at a photon energy of 91.2 eV. The absorption line may have a full width half maximum width of approximately 0.02 nm. This absorption line may correspond to a wavelength around 13.5 nm.

Using known fitting and data manipulation techniques , it may be possible to determine the center of the absorption line(s) with an accuracy that is higher than the width of the absorption line. Example fitting and data manipulation techniques may involve for example an appropriate fitting function (e.g. Gaussian fit, Lorentzian fit), or a center of gravity method in which the intensities of neighbouring pixels are used as weights to calculate a weighted average position. For example, it may be possible to determine the center of the krypton gas absorption line with an accuracy three times higher than the width of the line, i.e. around 0.006 nm. This level of accuracy may fall within the desired accuracy for wavelength calibration of a metrology apparatus. The desired accuracy may be related to the size of the structures to be measured by the metrology apparatus. This accuracy is higher than previous known calibration methods an assemblies that do not require moving components of the metrology setup. A result of the improved accuracy of the calibration may be an improved inference of properties of the metrology target based on measurements obtained by the calibrated detector(s). The measurements may be diffraction patterns from the metrology target detected by the one or more spectrometers. Therefore, accurate wavelength calibration as described herein may result in higher accuracy and higher precision measurements by the metrology apparatus. This may in turn lead to improved reproduction by the metrology apparatus.

A setup using krypton gas may be of particular interest for short-wavelength radiation which has wavelengths around 13.5nm. This may for example be the case for high harmonic generated radiation harmonics. For short wavelength radiation, materials with absorption lines in the correct part of the spectrum may be rare, and krypton gas offers a transmission window with narrow absorption lines in the EUV/SXR range of the spectrum. An alternative to krypton gas that may be used in some instances for the short wavelength range is helium. Another advantage of using gas for calibration may be that it enables calibration of a setup without requiring moving components of the metrology apparatus. This method of calibration may therefore be faster than alternative methods for example using a far-field spectrometer.

For a metrology setup described herein, the calibration accuracy of a spectrometer may be more than one order of magnitude smaller than the order of the wavelength, e.g. of an order of 0.1 nm, 0.01 nm or smaller for a wavelength of 13.5 nm. A spectrometer, in this instance, may be understood to be a sensor that is able to separately observe different wavelengths. In some instances a spectrometer may mean a sensor that itself disperses a radiation beam by some well-known structure that is periodic (e.g. in one direction), and then images the beam on a camera.

Figure 8 further shows a radiation input 806 for receiving the radiation, which may be the emitted radiation 342 as shown in Figure 6, to be calibrated. This radiation input may for example be connected to a HHG or LPP source, optionally for providing short wavelength radiation. The assembly may be provided inside a metrology apparatus for measuring a substrate located on a substrate table 812. Several components 810, which may be the illumination system 312 as in Figure 6, for directing the radiation may be present inside the metrology apparatus. In one embodiment, the illumination system irradiates at least part of the emitted radiation on the structure to generate one or more scattered radiations e.g. the reflected radiation 360 and the diffracted radiation 397. Such components may for example comprise a toroidal mirror for directing radiation onto a target substrate to be measured. A toroidal grating may be present on the mirror. Any components for the assembly 800 used for calibration may have to be provided to fit around the existing components 810 of the metrology apparatus. In one embodiment, at least one or part of the multiple detectors are arranged to detect at least part of the one or more scattered radiations or at least part of the (emitted) radiation.

The assembly 800 may further comprise a processing unit (which may also be referred to as a processor), which may comprise one or more processors and a memory, for performing data processing and calculations for determining the calibration. A processing unit may receive data collected by the one or more spectrometers. The data may represent the first radiation spectrum and the second radiation spectrum. The processing unit may perform other processing on the received data, e.g. noise reduction. The processing unit may receive other data related to the radiation spectra, such as time, date, pressure, temperature etc. of the assembly at the time of obtaining the spectra. In some implementations, the processing unit may be present at the assembly for the metrology apparatus, and the calibration may be determined at the apparatus. In alternative implementations, some of the processing and determination may be performed remotely, by transmitting the first and second radiation spectra data and any associated data to a processing unit remotely connected to the assembly, for example by a wired and/or wireless connection.

The difference between the second radiation spectrum and the first radiation spectrum on which the calibration is determined may comprise a ratio or a subtraction of the second radiation spectrum to the first radiation spectrum. This may for example involve dividing an image of the radiation spectrum obtained while krypton is present by an image of the radiation spectrum obtained while krypton was not present. This may reveal the absorption spectrum of the krypton gas without the distorting effect of the inherent spectral shape of the radiation source. For example, a Gaussian function or a Lorentzian function may be used to fit to the peaks in the absorption spectra to provide the positions of the absorption peaks with respect to the detector grid of the spectrometer with high accuracy. The spectra recorded with the detectors may then be analysed further using the absolute calibrated mapping of those wavelengths to pixels. The absolute wavelength calibration may be possible because the wavelength of the absorption line of krypton is narrow and known absolutely.

Further calibration of the spectrometer may be performed, for example using one or more known calibration methods. Using the absolute calibration of the spectrometer as described herein alongside other calibration methods may anchor the spectrum with respect to the wavelength axis. This may mean that fitting of geometric parameters like detector position and grating alignment, which have associated uncertainties, is no longer required. An additional advantage of using the methods described herein may be that if a plurality of spectrometer detectors are present, they may be intrinsically calibrated with respect to each other.

The achieved mapping may be unique for every individual detector. Therefore, a calibration of a spectrometer using the methods described herein may be based on radiation spectra measured by that same spectrometer.

In some implementations, a plurality of spectrometers may be present in the assembly. Each of the spectrometers may require calibration. Each spectrometer may be calibrated based on a radiation spectra measured by that spectrometer. Each spectrometer may be calibrated simultaneously, using the same krypton gas. In an example implementation, a metrology apparatus may comprise two spectrometers that require wavelength calibration: a first spectrometer and a second spectrometer. A first portion of the radiation may be directed to the first spectrometer, and a second portion of the radiation may be directed to the second spectrometer. The first spectrometer may measure a first radiation spectrum of the radiation and the second spectrometer may also measure a first radiation spectrum of the radiation, both while no krypton gas is provided to the assembly. Once the first radiation spectra have been measured, krypton gas may be added to the propagation path of both the first portion and the second portion of the radiation. The gas may be present in a part of the propagation path before the first and second portions are split, and/or the gas may be present in the parts of the radiation propagation paths where the first and second portions of the radiation are combined in the same radiation beam. The first spectrometer may measure a second radiation spectrum while the krypton gas is present and the second spectrometer may measure a second radiation spectrum while the krypton gas is present. The assembly may determine a wavelength calibration of the first spectrometer based on a difference between the first and second radiation spectra measured by the first spectrometer. The assembly may determine a wavelength calibration of the second spectrometer based on a difference between the first and second radiation spectra measured by the second spectrometer. The method described for two spectrometers above may be extended to three, four, or any other number of spectrometers.

A wavelength calibration of a spectrometer as described herein may comprise identifying a position on the spectrometer where the absorption line (e.g. for a wavelength around 13.5 nm) of krypton is located. This location may be determined based on the difference of the first radiation spectrum in which the wavelengths of the radiation are present, and the second radiation spectrum in which wavelengths absorbed by krypton gas has been significantly removed. The position on the spectrometer where this difference between the first and second spectra occurs may be associated with the corresponding absorption line of krypton gas. Once this position has been calibrated to the krypton absorption line, the position of the rest of the wavelengths of the radiation on the spectrometer may be determined relative to this calibrated wavelength.

A spectrometer may be provided in the metrology apparatus for example to monitor source fluctuations. A spectrometer may be provided in a reference arm of a metrology apparatus. A spectrometer may additionally or alternatively be provided in a measurement arm of the metrology apparatus. In an example implementation, a spectrometer may be positioned to detect a first order diffracted radiation, diffracted from a component in the metrology setup. The component may for example be a focussing mirror comprising a variable line spacing grating. The received spectrum may be a reference spectrum obtained to monitor source fluctuations. It may calibrate the radiation which is focussed on the target substrate to be measured. The reference spectrum captured by the detector of the spectrometer may be compared with a spectrum that is obtained after interaction with the target substrate.

The one or more spectrometers for the metrology apparatus may be located inside a metrology vessel. The metrology vessel may be a chamber inside the metrology apparatus in which the spectrometers are present. The chamber may further be configured to comprise the targets substrate to be measured by the metrology apparatus, as well as components to control the radiation for measurement. The radiation may propagate through the chamber. A substrate to be measured may be located inside the chamber. Other components of the metrology apparatus may also be present inside the chamber (e.g. optics, actuators). During use, the metrology chamber may be held under vacuum conditions. Under normal operation, when no krypton gas has been added, the metrology chamber may be held at a vacuum pressure around an order of 1 × 10⁻⁵ mbar, or in a range of 1 × 10⁻⁴ mbar to 1 × 10⁻⁶ mbar. When krypton gas is added to the chamber, the pressure inside the vessel may increase. If krypton gas is added to the whole vessel, the pressure may be in a range from 1 × 10-3 mbar to 1 × 10-2 mbar. If a gas cell is provided, to which the gas is configured to be added, as discussed in more detail below, the increase in vessel pressure may be less when adding krypton gas, for example in a range of 1 × 10⁻⁵ mbar to 1 × 10⁻⁴ mbar.

In some implementations, the krypton gas may be added into the chamber, which may then act as a vessel to hold the krypton gas. The chamber may comprise one or more gas inlets, and may comprise one or more gas outlets, for adding and removing the krypton gas respectively. A gas outlet may comprise a vacuum pump of the vacuum system. The krypton gas may be added to the vessel at a pressure in a range of 0.0001 mbar to 1 mbar. The pressure of the krypton gas at may for example be 0.01 mbar inside the vessel/chamber. Adding the krypton gas to the vessel may take in the order of seconds (e.g. 1 s - 10 s). Removing the krypton gas and bringing the pressure back to pre-krypton levels may take in the order of one or more minutes. Removing the krypton from the vessel may be faster (e.g. in the order of 10s of seconds to one or more minutes) when a gas cell is used compared to when gas is added to the whole vessel. These pressures may be managed by the vacuum pump system of the metrology apparatus. The pressure mentioned may be the pressure at the time of measuring the second radiation spectrum. The pressure may ramp up to this value before taking the measurement, and may ramp down to a lower pressure after the measurement.

The pressure of krypton gas may be selected such that the amount of krypton gas is large enough to have a noticeable effect on the radiation spectrum (such that the absorption line can be observed). The amount of krypton gas may be low enough such that the effect of the gas on the radiation spectrum is limited to absorbing the radiation of the wavelength of the absorption line, and does not comparatively affect the other radiation wavelengths. The skilled person will understand that the pressure range of krypton gas in which the desired absorption behaviour is observed may depend on the propagation length of the radiation through the krypton gas. The amount of interaction between the radiation and the krypton gas may depend on the pressure of the krypton gas as well as the propagation length of the radiation through the gas. In case the krypton gas is added to the metrology vessel, the interaction length of the radiation with the krypton gas may be equal to the propagation length of the radiation through the metrology vessel. The radiation may have a propagation length through the metrology vessel in a range of 10 cm to 5 m, for example in a range of 50 cm - 150 cm, or 60 cm to 150 cm, or 50 cm to 150 cm. When using a gas cell, the propagation length inside the gas cell may be in a range from 5 cm to 15 cm. The gas cell may comprise an inlet and an outlet for the radiation to pass through. In one embodiment, propagation length of the radiation in the gas cell is in a range of 5 mm and 20 cm, such as 10 cm.

An advantage of adding the krypton gas directly into the chamber of the apparatus may be that it is a simple solution which does not require a lot of space or additional components or structures inside the metrology apparatus.

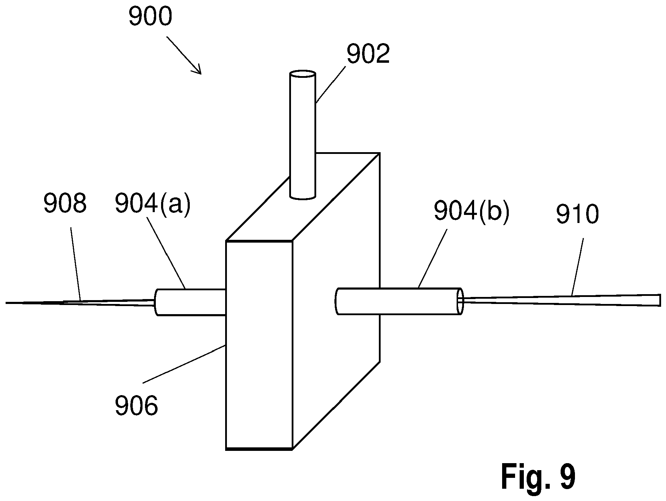

In some implementations, a gas cell may be provided in the chamber. A gas cell may sometimes be referred to as a flushbox. The propagation path of the radiation may pass through the gas cell. The gas supply system may comprises a gas cell. Figure 9 depicts a schematic representation of the gas cell 900. In one embodiment the gas supply system comprises a gas nozzle, as the gas nozzle 609 in figure 7. The gas cell may have a gas inlet 902 and one or more gas outlets 904(a)-904(b). The gas inlet 902 may be an inlet tube attached to a cell body 906 the gas cell. The gas outlet 904(a)-904(b) may be two outlet tubes. The outlet tubes may be positioned such that the propagation path of the radiation passes along a channel formed by the outlet tubes 904(a) and 904(b). The outlet tubes may therefore act as an input end for radiation 908 input to the gas cell, and an output end for outputting radiation 910 from the gas cell 900. Other gas cell shapes may be used, for example a gas cell body wherein the inlet and/or outlets are not tubes/tube-shaped, or using a T-shaped tube wherein the base may serve as an inlet and the two arms may serve as outputs.

An advantage of using a gas cell is that it allows for a lower krypton gas flow to be used compared to inserting the krypton gas straight into the chamber as a vessel, as a smaller area needs to be filled with gas. It also allowed the chamber to be kept at a lower pressure compared to when gas is injected into the whole chamber as a vessel. The gas cell should be provided in the propagation path of the radiation, which may already be in a confined area with limited space for additional components.

Inside the outlet tubes 904(a)- 904(b), the gas may achieve a laminar flow due to the pressure regimes present in the metrology apparatus, not a turbulent flow. This laminar flow may be advantageous as turbulent flow may lead to localised pressure differences that change over time and may make the resulting total interaction of the radiation with krypton gas less constant.

The propagation length of the radiation in the gas cell may be in a range of 5 mm and 20 cm, such as 10 cm. The propagation length of the radiation in the gas cell 900 may be at least 10 cm, or in a range of 10 cm to 20 cm. The propagation length inside the gas cell may include the lengths of the two outlet tubes. The propagation length may be used to determine an interaction length of the radiation with the krypton gas, When determining the interaction length, the length of the tubes may be weighted with a weighting factor. This may be because the gas pressure inside the tubes may decrease towards the end of the tubes. This may lead to a reduced interaction of the radiation with the gas.

Similarly to when providing gas directly into the chamber acting as a vessel, the amount of krypton gas needs to be enough such that the absorption of the radiation at the krypton absorption line is noticeable (measurable), and not too high so that the other wavelengths of the radiation are substantially affected. As the gas is only provided along a portion of the propagation length of the radiation, the krypton gas pressure inside the gas cell required to achieve this may need to be higher than the krypton gas pressure in the chamber. The actual pressure required may depend on the interaction length of the radiation with the krypton gas.

The size of the cell body 906 of the gas cell may also affect the amount of gas flow/gas pressure needed. A bigger cell may require lower gas pressure and a lower gas flow than a smaller cell to achieve the same amount of interaction of the radiation with the gas. Based on a range of propagation length of radiation inside the gas cell in a range of 5 mm to 20 cm as described above, the pressure of the gas inside the gas cell may be in a range of 0.1 mbar to 2 mbar. The pressure of the gas may be taken as the pressure in the cell body 906 of the gas cell. The pressure of the gas may vary towards the outlet ends 904(a) - 904(b) of the gas cell 900.

In some implementations, the gas cell may comprise one or more components of the metrology apparatus, for example one or more optical components for guiding the radiation inside the metrology apparatus. A gas cell may for example be provided around a focussing mirror. This may have an additional advantage that the gas cell 900 may act as a flushbox for the component.

In some instances, the above methods may encounter issues if the visibility of the absorption peaks of the calibration gas in the second radiation spectrum is poor. This may for example occur of the change in spectrum between the gas being present and absent is smaller than the noise levels of the detector. In such instances, the visibility of the peaks may be increased using lock-in detection. Lock-in detection may be performed using a calibration assembly comprising a gas cell, for example as described in relation to figure 9. The lock-in technique comprises modulating the pressure of the gas at a known frequency, while a time series of images are captured by the spectrometer. The gas pressure modulation may be implemented for example using a pulsed gas valve. The pulsed gas valve may be piezo-controlled. Subsequently, the time series of images are analysed, and the signal components that do not vary at the same frequency as the applied pulsed pressure ae filtered out of the image(s) of the spectrum. The remaining portion of the spectrum are the components of the radiation spectrum that do vary at the same frequency of the pulsed pressure, which may be the absorption peaks of the gas.

An advantage of using lock-in detection may be that it enables lower gas pressures to be used, such that the difference between radiation spectra with and without the gas pressure is smaller than the noise level of the spectrometer(s) to be calibrated. This may mean less gas is needed for the calibration, meaning the pressure inside the metrology apparatus may be kept lower.

While the methods and assemblies have been described above in relation to krypton gas, which may be a particularly relevant gas for radiation comprising wavelengths in the 1 nm - 20 nm range, the same methods may be implemented using other gases. The suitability of a gas may depend on several factors, including the wavelength(s) at which absorption lines occur and the thickness of the absorption line. Once example gas that may be used is Helium, which has the same noble gas advantages as krypton. Helium also has an absorption peak in the 1 nm - 20 nm range. Other gasses that may be useful include phosphor-based gasses (e.g. phosphine PH₃), silicon-based gasses (e.g. silane SiH₄), sulphur-based gasses (e.g. sulphur dioxide SO₂), boron-based gasses (e.g. boron trichloride BCl₃).

In case the absorption peak of a gas falls in a valley of a comb of a radiation spectrum, the effects of the absorption by the gas would be hard to observe. In order to overcome this challenge, on or more parameters of the radiation source may be varied to change the spectrum output by the radiation source. Examples of parameters to be varied may include drive laser wavelength (which shift the peaks), pulse length of the pulsed drive laser (shorter pulse length will broaden the peaks), missing the drive laser with second harmonics of the drive laser will add more peaks in even harmonics. The pressure inside the generation medium of the drive laser may be changed, which may induce a wavelength shift in generated harmonics. Changing these parameters may require significant altering of the metrology/source setup. Changing the parameters may for example lead to a shift in the spectrum such that the absorption line overlaps with a peak in the radiation spectrum. Additionally or alternatively, changing the parameters may lead to broadening the spectrum such that the absorption line falls within the broadened peak of the spectrum.

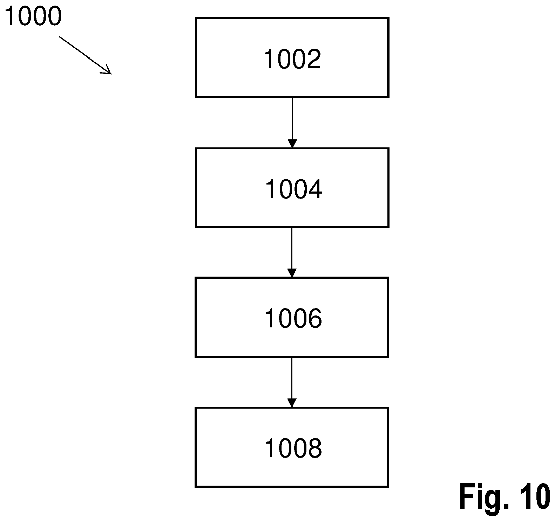

Figure 10 depicts a flow chart of a method 1000 for wavelength calibration or radiation for one or more spectrometers of a metrology apparatus, as described herein. In step 1002 one or more spectrometers measure a first radiation spectrum of the radiation. Once the first radiation spectrum has been measured, an amount of krypton (or helium, or other suitable) gas is added 1004 to a propagation path of the radiation in the metrology apparatus The gas has an absorption line that overlaps with at least one wavelength of the radiation. While the gas is present in the propagation path, the one or more spectrometers measure 1006 a second radiation spectrum. A wavelength calibration of the one or more spectrometers is then determined 1008 based on a difference between the second radiation spectrum and the first radiation spectrum.

Described above are assemblies and methods for calibrating radiation wavelengths for spectrometers in a metrology apparatus by adding a gas to the propagation path of the radiation, wherein the gas has an absorption line that overlaps with a wavelength of the radiation. Instead of adding a gas, other wavelength-selective elements with known absorption lines could be added to the propagation path of the radiation.

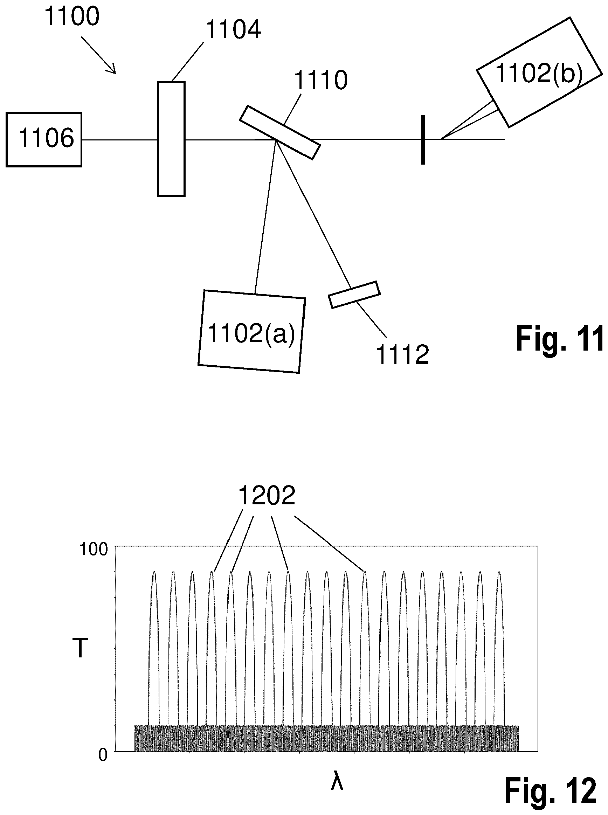

Figure 11 depicts a schematic representation of an assembly 1100 for wavelength calibration of radiation used in a metrology apparatus. The metrology apparatus comprises one or more spectrometers 1102(a), 1102(b) to be calibrated. The metrology apparatus may have properties of the metrology apparatus described in relation to figure 8 above but instead of a gas, a wavelength-selective filter 1104 is added to the propagation path of the radiation. The wavelength-selective filter 1104 may have an absorption line that overlaps with at least one wavelength of the radiation. Radiation input 1106 may provide radiation to the assembly 1100, similar to radiation input 806 described above. One or more optical components 1110 may be provided to interact with the radiation. A substrate table 1112 configured to hold a target substrate to be measured may also be provided inside the chamber of the metrology apparatus.

An advantage of using a wavelength-selective filter may be that the filter may be designed to select a desired wavelength for transmission/reflection. The wavelength may therefore be tuned for a specific radiation spectrum to be calibrated. This is in contrast to adding a gas, where the absorption line is a set property of the material. Introducing a filter into the metrology apparatus may also be simpler than adding a gas.

The wavelength-selective filter may be a solid thin film filter. The thin film filter may be a suitable silicon-based material, e.g. silicon nitride, pure silicon. A thin film filter may be designed be selecting the thickness of one or more layers of filter in order to select a specific bandwidth of light. A thin film filter may further be designed by selecting the material and its associated wavelength properties. The filter may be a transmissive filter. The transmissive filter may comprise a plurality of filters. The filter may be a multiple-cavity filter. In a multi-cavity filter may comprise a plurality of thin film bandpass filters, as illustrated in figure 12. Figure 12 depicts a schematic graph of transmission T (in a range of 0% and 100%) as a function of wavelength λ. The filter may have high transmission for a plurality of peaks 1202 for which transmission is high. The filter may have a well-defined spectral properties, for example by being measured using a radiation source with well-defined wavelength properties. By placing the transmissive filter in the path of the radiation before it hits the spectrometer, the resulting measured spectrum may be of the radiation convoluted with the filter. A spectrometer may be calibrated based on the measured spectra (with and without filter present) and knowledge of the transmissive filter.

In some implementation, the filter may be a reflective filter, such as a multilayer mirror. The reflective be designed to reflect only certain wavelengths, This may for example be achieved by adding a multilayer coating to a mirror to reflect only selected wavelengths. The layer thickness and material choice may be used to design the wavelength reflective properties of the mirror. As well as the layers of the multilayer mirror, the angle of incidence of the radiation onto the mirror may be used to select which wavelengths will be reflected (as the angle of incidence changes the propagation length of the radiation through the layers). By changing the angle of incidence, the reflected mirror may be tuned by several nanometers, depending on the exact angle of incidence.

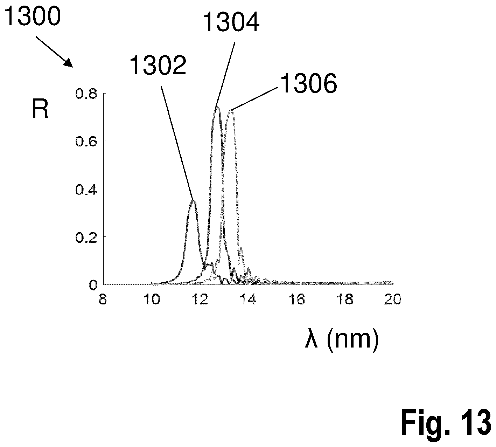

Figure 13 depicts a model graph 1300 of reflective properties of an example mirror for different angles of incidence. The x-axis sets out the wavelength of the radiation, the y-axis sets out the reflectivity. Curve 1302 shows an example reflectivity curve for an angle of incidence of 60°. Curve 1304 shows an example reflectivity curve for an angle of incidence of 70°. Curve 1306 shows an example reflectivity curve for an angle of incidence of 80°. The mirror may be a Si/Mo multilayer mirror comprising 40 layers. Each layer may have a thickness of 6.9 nm. This model graph is provided as an example only, and other mirror designs and angles of incidence may be used.

A multilayer mirror as reflective filter may be positioned before a toroidal grating, to filter out specific wavelengths within the radiation spectrum. These wavelengths can then be used to calibrate the spectrum on the detector with a higher accuracy. Different configurations of mirrors may be used to reflect radiation onto the toroidal grating. In an example configuration, two mirrors may displace the beam laterally onto the toroidal grating. This may result in the radiation reaching the detector and grating also being shifted, which may complicate the calibration. In another example configuration, four mirrors may be positioned in front of the grating. In the case that the mirrors are placed correctly with respect to each other, the radiation beam should not shift, and no additional difficulty is imposed on the calibration.

In some configurations, the mirrors may be placed on an actuating stage, for example a rotational stage. By enabling actuation, the angle of incidence may be tuned, for example to achieve angle of incidence tuning as described in relation to figure 13. Tuning the reflected wavelengths may impact the spectrum of the radiation that reaches the detector. By rotating the mirrors, different wavelength(s) may experience the highest reflectivity. While the design of the mirror (material, number of layers, and coating) cannot be changed once it is produced, rotating the angle can be used to create a change in reflected spectrum.

While adding a wavelength-selective filter may allow for wavelength calibration of a spectrometer, it may be advantageous to have two points for calibration. Having two well defined points may enable constructing the energy axis as a separate calibration method without being dependent on other parameters or input. In an example, one wavelength may be used to calibrate the spectrometer, and the spacing between harmonics of the radiation may then be used to reconstruct the entire energy axis. This spacing may be highly dependent on the wavelength of the fundamental (pump) laser pulse in the interaction area (e.g. a gas jet), so that it may itself require another calibration. Furthermore, the geometry and incidence angles of the toroidal mirror comprising a grating may be identified/calibrated such that the entire energy axis can be reconstructed with one point.
An assembly for wavelength calibration of radiation used in a metrology apparatus may be provided, the metrology apparatus comprising one or more spectrometers. The assembly may be configured to measure, by the one or more spectrometers, a first radiation spectrum of the radiation. After the first radiation spectrum has been measured, a first wavelength-selecting element and a second wavelength-selecting element may be added to a propagation path of the radiation in the metrology apparatus. The first wavelength-selecting element may have a first absorption line that overlaps with at least a first wavelength of the radiation. The second wavelength-selecting element may have a second absorption line that overlaps with at least a second wavelength of the radiation. The first wavelength and the second wavelength are different. While the wavelength-selecting elements are present in the propagation path of the radiation, the one or more spectrometers each measure a second radiation spectrum. A wavelength calibration may be determined for the one or more spectrometers based on a difference between the second radiation spectrum and the first radiation spectrum. In one embodiment, the wavelength calibration is determined for one spectrometer. In one embodiment, the multiple detectors are configured to measure the absorption line simultaneously. In one embodiment, the wavelength calibration is determined for more than one spectrometers simultaneously.

If two points of calibration are used, any two combinations of a gas, a solid thin film, a transmissive filter, and a reflective filter could be used. For example, a gas and a transmissive filter, or a first gas and a second gas, or a transmissive filter and a reflective filter, etc.

An embodiment may include a computer program containing one or more sequences of machine-readable instructions describing a method of optical metrology and/or a method of analyzing a measurement to obtain information about a lithographic process. An embodiment may comprise computer code containing one or more sequences of machine-readable instructions or data describing the method. This computer program or code may be executed for example within unit MPU in the apparatus of Figure 6 and/or the control unit CL of Figure 3. There may also be provided a data storage medium (e.g., semiconductor memory, magnetic or optical disk, etc.) having such a computer program or code stored therein. Where an existing metrology apparatus, for example of the type shown in Figure 6, is already in production and/or in use, an embodiment of the invention can be implemented by the provision of an updated computer program product for causing a processor to perform one or more of the methods described herein. The computer program or code may optionally be arranged to control the optical system, substrate support and the like to perform a method of measuring a parameter of the lithographic process on a suitable plurality of targets. The computer program or code can update the lithographic and/or metrology recipe for measurement of further substrates. The computer program or code may be arranged to control (directly or indirectly) the lithographic apparatus for the patterning and processing of further substrates.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:
1. An assembly for wavelength calibration of radiation, wherein the assembly comprises:
   one or more spectrometers configured to:
      measure a first radiation spectrum of the radiation;
      measure a second radiation spectrum while krypton gas is present in a propagation path of the radiation, wherein the krypton gas has an absorption line that overlaps with at least one wavelength of the radiation; and
   a processor configured to determine a wavelength calibration of the one or more spectrometers based on a difference between the second radiation spectrum and the first radiation spectrum.
2. An assembly according to any of the preceding clauses, wherein the difference is a ratio of the second radiation spectrum to the first radiation spectrum.
3. An assembly according to any of the preceding clauses, wherein the radiation comprises one or more wavelengths in a range of 1 nm to 100 nm, or 1 nm to 10 nm, or 10 nm to 20 nm, or 0.1 nm to 10 nm.
4. An assembly according to any of the preceding clauses, wherein the assembly comprises a plurality of spectrometers, and wherein the assembly is configured to determine a wavelength calibration of each of the plurality of spectrometers.
5. An assembly according to any of the preceding clauses, wherein the processor is configured to, to determine the wavelength calibration, for each of the one or more spectrometers:
   identify a position on the spectrometer where the absorption line of the krypton gas is located based on the difference of the second radiation spectrum and the first radiation spectrum; and
   calibrate the wavelength corresponding to the absorption line of krypton to the position of the absorption line.
6. An assembly according to any of the preceding clauses, wherein the absorption line of krypton is associated with a photon energy in a range of 90 eV to 95 eV, such as with a wavelength of 13.5 nm.
7. An assembly according to any of the preceding clauses, wherein the one or more spectrometers are configured to be provided inside a metrology or inspection vessel, wherein the radiation is configured to propagate inside the metrology or inspection vessel, and wherein the krypton gas is configured to be added to the metrology or inspection vessel.
8. An assembly according to clause 7, wherein the assembly further comprises a gas module configured to add krypton gas inside the metrology or inspection vessel at a pressure in a range of 0.0001 mbar to 1 mbar, such as a pressure of 0.01 mbar.
9. An assembly according to any of clauses 7-8, wherein the propagation length of the radiation inside the metrology or inspection apparatus is in a range of 10 cm to 5 m, such as in a range from 60 cm - 150 cm, or 50 cm - 70 cm.
10. An assembly according to any of clauses 1-6, wherein the assembly further comprises a gas cell, and wherein the krypton gas is configured to be added to the gas cell.
11. An assembly according to clause 10, wherein the gas cell comprises an inlet tube and two outlet tubes, wherein the outlet tubes are further configured to function as input end of the gas cell and output end of the gas cell for the radiation.
12. An assembly according to any of clauses 10 - 11, wherein the propagation length of the radiation in the gas cell is in a range of 5 mm and 20 cm, such as 10 cm.
13. An assembly according to any of the preceding clauses, wherein measuring a first radiation spectrum and a second radiation spectrum comprises performing lock-in detection.
14. An assembly according to any of the preceding clauses, wherein the one or more spectrometers comprise a spectrometer in a reference arm of a metrology or inspection apparatus.
15. An assembly according to any of the preceding clauses, wherein the one or more spectrometers comprise a spectrometer in a measurement arm of the metrology or inspection apparatus.
16. A method for wavelength calibration of radiation, the method comprising:
   measuring, by one or more spectrometers, a first radiation spectrum of the radiation;
   measuring, by the one or more spectrometers, a second radiation spectrum while krypton gas is present in the propagation path of the radiation, wherein the krypton gas has an absorption line that overlaps with at least one wavelength of the radiation; and
   determining, by a processor, a wavelength calibration of the one or more spectrometers based on a difference between the second radiation spectrum and the first radiation spectrum.
17. An assembly for wavelength calibration of radiation, wherein the assembly comprises:
   one or more spectrometers, configured to:
      measure a first radiation spectrum of the radiation;
      measure a second radiation spectrum while helium gas is present in a propagation path of the radiation, wherein the helium gas has an absorption line that overlaps with at least one wavelength of the radiation; and
   a processor configured to determine a wavelength calibration of the one or more spectrometers based on a difference between the second radiation spectrum and the first radiation spectrum.
18. An assembly for wavelength calibration of radiation, wherein the assembly comprises:
   one or more spectrometers, configured to:
      measure a first radiation spectrum of the radiation;
      measure a second radiation spectrum while a wavelength-selective filter is present in a propagation path of the radiation, wherein the wavelength-selective filter has an absorption line that overlaps with at least one wavelength of the radiation; and
   a processor configured to determine a wavelength calibration of the one or more spectrometers based on a difference between the second radiation spectrum and the first radiation spectrum.
19. An assembly according to clause 18, wherein the wavelength-selective filter is a solid thin film filter.
20. An assembly according to any of clauses 18 - 19, wherein the wavelength-selective filter is a transmissive filter.
21. An assembly according to any of clauses 19 - 20, wherein the wavelength-selective filter is a multi-cavity filter.
22. An assembly according to any of clauses 18 - 19, wherein the wavelength-selective filter is a reflective filter.
23. An assembly according to clause 22, wherein the wavelength-selective filter is a multilayer mirror.
24. An assembly according to any of clauses 22 - 23, wherein the angle of incidence of the radiation onto the reflective filter is selected to tune the reflected wavelengths.
25. An assembly for wavelength calibration of radiation, wherein the assembly comprises:
   one or more spectrometers, configured to:
      measure a first radiation spectrum of the radiation;
      measure a second radiation spectrum while a first wavelength-selecting element and a second wavelength-selecting element are present in a propagation path of the radiation, wherein the first wavelength-selecting element has a first absorption line that overlaps with at least a first wavelength of the radiation, and the second wavelength-selecting element has a second absorption line that overlaps with at least a second wavelength of the radiation, and wherein the first wavelength and the second wavelength are different; and
   a processor configured to determine a wavelength calibration of the one or more spectrometers based on a difference between the second radiation spectrum and the first radiation spectrum.
26. An assembly according to clause 25, wherein the first wavelength-selecting element is one of a solid thin film, Krypton gas, Helium gas, a transmissive filter, or a reflective filter.
27. An assembly according to any of clauses 25 - 26, wherein the second wavelength-selecting element is not identical to the first wavelength-selecting element, and is one of a solid thin film, Krypton gas, Helium gas, a transmissive filter, or a reflective filter.
28. A metrology apparatus comprising an assembly according to any of clauses 1 - 15, and 17 - 27.
29. An inspection apparatus comprising an assembly according to any of clauses 1 - 15, and 17 - 27.
30. A lithography apparatus comprising an assembly according to any of clauses 1 - 15, and 17 - 27.
31. A litho cell comprising an apparatus according to any of clauses 28 - 30.
32. An assembly, comprising:
   A radiation input configured to receive an emitted radiation,
   An illumination system arranged to irradiate at least part of the emitted radiation on the structure to generate one or more scattered radiations;
   Multiple detectors, wherein at least part of the multiple detectors are arranged to detect at least part of the one or more scattered radiations or at least part of the emitted radiation; and A gas supply system configured to provide a gas to absorb part of the emitted radiation to create an absorption line on spectrums of the one or more scattered radiations and the at least part of the emitted radiation;
   Wherein the multiple detectors are configured to measure the absorption line simultaneously.
33. An assembly according to clause 32, wherein the gas is a noble gas.
34. An assembly according to clause 33, wherein the noble gas is krypton.
35. An assembly according to any of clauses 32 to 34, wherein the absorption line is used for measuring the spectrums of the one or more scattered radiations and/or the at least part of the emitted radiation.
36. An assembly according to any of clauses 32 to 35, wherein the spectrums are different on the multiple detectors.
37. An assembly according to any of clauses 32 to 36, wherein the assembly is for measuring a parameter of a structure on a substrate, and the at least part of the multiple detectors are arranged to detect the at least part of the one or more scattered radiations to measure the parameter.
38. An assembly according to clause 37, wherein the parameter is a profilometry parameter.
39. An assembly according to any of clauses 32 to 38, wherein the emitted radiation comprises one or more wavelengths in a range of 1 nm to 100 nm, or 1 nm to 10 nm, or 10 nm to 20 nm, or 0.1 nm to 10 nm.
40. An assembly according to any of clauses 32 to 39, wherein the assembly further comprises a gas cell, and wherein the gas is configured to be added to the gas cell.
41. An assembly according to clause 40, wherein the gas cell comprises an inlet and an outlet for the emitted radiation.
42. An assembly according to clause 41, wherein propagation length of the radiation in the gas cell is in a range of 5 mm and 20 cm, such as 10 cm.
43. An assembly according to any of clauses 32 to 42, wherein the radiation input is connected to a high harmonic generation (HHG) source or a laser produced plasma (LPP) source.
44. An inspection apparatus comprising an assembly according to any of clauses 32 to 43.
45. An metrology apparatus comprising an assembly according to any of clauses 32 to 43.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to HXR, SXR and EUV electromagnetic radiations, it will be appreciated that the invention, where the context allows, may be practiced with all electromagnetic radiations, including radio waves, microwaves, infrared, (visible) light, ultraviolet, X-rays, and gamma rays.

Additional objects, advantages and features of the present invention are set forth in this specification, and in part will become apparent to those skilled in the art on examination of the following, or may be learned by practice of the invention. The inventions disclosed in this application are not limited to any particular set of, or combination of, objects, advantages and features. It is contemplated that various combinations of the stated objects, advantages and features make up the inventions disclosed in this application.

## Claims

1. An assembly, comprising:
A radiation input configured to receive an emitted radiation,
An illumination system arranged to irradiate at least part of the emitted radiation on the structure to generate one or more scattered radiations;
Multiple detectors, wherein at least part of the multiple detectors are arranged to detect at least part of the one or more scattered radiations or at least part of the emitted radiation; and
A gas supply system configured to provide a gas to absorb part of the emitted radiation to create an absorption line on spectrums of the one or more scattered radiations and the at least part of the emitted radiation;
Wherein the multiple detectors are configured to measure the absorption line simultaneously.

2. An assembly according to claim 1, wherein the gas is a noble gas.

3. An assembly according to claim 2, wherein the noble gas is krypton.

4. An assembly according to any of the preceding claims, wherein the absorption line is used for measuring the spectrums of the one or more scattered radiations and/or the at least part of the emitted radiation.

5. An assembly according to any of the preceding claims, wherein the spectrums are different on the multiple detectors.

6. An assembly according to any of the preceding claims, wherein the assembly is for measuring a parameter of a structure on a substrate, and the at least part of the multiple detectors are arranged to detect the at least part of the one or more scattered radiations to measure the parameter.

7. An assembly according to claim 6, wherein the parameter is a profilometry parameter.

8. An assembly according to any of the preceding claims, wherein the emitted radiation comprises one or more wavelengths in a range of 1 nm to 100 nm, or 1 nm to 10 nm, or 10 nm to 20 nm, or 0.1 nm to 10 nm.

9. An assembly according to any of the preceding claims, wherein the assembly further comprises a gas cell, and wherein the gas is configured to be added to the gas cell.

10. An assembly according to claim 9, wherein the gas cell comprises an inlet and an outlet for the emitted radiation.

11. An assembly according to claim 10, wherein propagation length of the radiation in the gas cell is in a range of 5 mm and 20 cm, such as 10 cm.

12. An assembly according to any of the preceding claims, wherein the radiation input is connected to a high harmonic generation (HHG) source or a laser produced plasma (LPP) source.

13. An assembly for wavelength calibration of radiation, wherein the assembly comprises:
one or more spectrometers configured to:
measure a first radiation spectrum of the radiation;
measure a second radiation spectrum while krypton gas is present in a propagation path of the radiation, wherein the krypton gas has an absorption line that overlaps with at least one wavelength of the radiation; and
a processor configured to determine a wavelength calibration of the one or more spectrometers based on a difference between the second radiation spectrum and the first radiation spectrum.

14. An inspection apparatus comprising an assembly according to any of claims 1 - 13.

15. An metrology apparatus comprising an assembly according to any of claims 1 - 13.
